# EUROPEAN PATENT APPLICATION

(11) **EP 4 701 350 A1**
(43) Date of publication of application: **25.02.2026**
(21) Application number: 25726200.6
(22) Date of filing: 20.05.2025
(51) Int. Cl.: H05K 1/02, H05K 5/00, H05K 5/03, H05K 3/46

(54) **RIGID-FLEXIBLE CIRCUIT BOARD AND ELECTRONIC DEVICE COMPRISING SAME**

(30) Priority: 02.07.2024 KR 20240087078; 04.09.2024 KR 20240120282
(71) Applicant: Samsung Electronics Co., Ltd, Suwon-si, Gyeonggi-do 16677 (KR)
(72) Inventor: LEE, Youngsun, Suwon-si, Gyeonggi-do 16677 (KR); KIM, Seunghwan, Suwon-si, Gyeonggi-do 16677 (KR); RA, Jaeyeon, Suwon-si, Gyeonggi-do 16677 (KR); PARK, Sungwon, Suwon-si, Gyeonggi-do 16677 (KR); YOON, Kyoungsik, Suwon-si, Gyeonggi-do 16677 (KR); HONG, Eunseok, Suwon-si, Gyeonggi-do 16677 (KR)
(74) Representative: Nederlandsch Octrooibureau
(86) International application number: PCT/KR2025/006826
(87) International publication number: WO 2026/010148

(57) **Abstract**

The rigid flexible printed circuit board according to various embodiments of the disclosure may be a rigid flexible printed circuit board having a flexible part and a rigid part. The rigid flexible printed circuit board may include a flexible substrate layer that includes at least one flexible conductor layer and at least one flexible insulating layer stacked on the at least one flexible conductor layer. The rigid flexible printed circuit board may include a rigid insulating layer, in the rigid part, which is stacked on the flexible substrate layer and has higher rigidity compared to the flexible insulating layer. The rigid insulating layer may include a recessed portion that is formed by recessing the side surface of the rigid insulating layer at the boundary between the flexible part and the rigid part.

## Description

### [Technical Field]

The present disclosure relates to a printed circuit board and, more particularly, to a rigid flexible circuit board and an electronic device including the same.

### [Background Art]

An electronic device may include a circuit board on which various electrical components are arranged. Among the components arranged on the circuit board, components such as a switch, fingerprint sensor, camera, and antenna may be disposed in various directions inside the electronic device. Hence, the circuit board on which these components are arranged may be placed in a warped or bent state within the electronic device. In addition, if the electronic device is a foldable electronic device having a plurality of foldable housings, the circuit board connecting the plurality of housings may be configured to be bendable.

Circuit boards that require bending may include, for example, a flexible printed circuit board (FPCB) in which a layer of conductors is stacked on a flexible base or the like. The flexible printed circuit board may be easily disposed along a curved path, but may lack the rigidity required to place electrical components in place. Therefore, a circuit board that can satisfy the need for both high rigidity and high bendability, such as a rigid flexible printed circuit board that has high rigidity in the region where rigidity is required and high flexibility in the region where bending is required, may be used.

The above information may be provided as related art for the purpose of assisting in understanding the disclosure. No claim or determination is made as to whether any of the above is applicable as prior art related to the disclosure.

### [Disclosure of Invention]

### [Technical Problem]

When the flexible part of a rigid flexible circuit board is bent inside the electronic device, a bending moment may be applied to the flexible part. When a high bending moment is applied to the flexible part of the rigid flexible circuit board, a strong stress may occur at the boundary between the flexible part and the rigid part, which may cause breakage of the flexible part of the rigid flexible circuit board and cracking of the conducting wire. To prevent such breakage and cracking, the length of the flexible part of the rigid flexible circuit board can be increased so that the bending moment is distributed over a wide range. However, as the interior of the electronic device becomes narrower, the need for the flexible part of the rigid flexible circuit board to be tightly bent increases. Hence, the risk of damage and cracking of the rigid flexible circuit board increases due to a high bending moment. In addition, increasing the length of the flexible part of the rigid flexible circuit board within the limited internal space of the electronic device entails reducing the length of the rigid part, which may result in a reduction in the area of the rigid part where electrical components are to be disposed.

According to various embodiments of the disclosure, it is possible to provide a rigid flexible circuit board having a reduced risk of damage due to bending and an increased component placement space, and an electronic device including the same.

### [Solution to Problem]

The electronic device according to various embodiments of the disclosure may be an electronic device including a circuit board having a flexible part and a rigid part. The circuit board may include a flexible substrate layer that includes at least one flexible conductor layer and at least one flexible insulating layer stacked on the at least one flexible conductor layer. The circuit board may include a rigid insulating layer, in the rigid part, which is stacked on the flexible substrate layer and has higher rigidity compared to the flexible insulating layer. The rigid insulating layer may include a recessed portion that is formed by recessing the side surface of the rigid insulating layer at the boundary between the flexible part and the rigid part.

The rigid flexible printed circuit board according to various embodiments of the disclosure may be a rigid flexible printed circuit board having a flexible part and a rigid part. The rigid flexible printed circuit board may include a flexible substrate layer that includes at least one flexible conductor layer and at least one flexible insulating layer stacked on the at least one flexible conductor layer. The rigid flexible printed circuit board may include a rigid insulating layer, in the rigid part, which is stacked on the flexible substrate layer and has higher rigidity compared to the flexible insulating layer. The rigid insulating layer may include a recessed portion that is formed by recessing the side surface of the rigid insulating layer at the boundary between the flexible part and the rigid part.

The manufacturing method according to various embodiments of the disclosure may be a method for manufacturing a rigid flexible printed circuit board having a flexible part and a rigid part, and may include attaching a release film having a specific length on a flexible substrate. The manufacturing method may include stacking a prepreg on the flexible substrate to which the release film is attached. The manufacturing method may include removing the release film.

The rigid flexible printed circuit board according to various embodiments of the disclosure may be a rigid flexible printed circuit board having a flexible part and a rigid part, and may be manufactured by a manufacturing method composed of attaching a release film having a specific length on a flexible substrate, stacking a prepreg on the flexible substrate to which the release film is attached, and removing the release film.

### [Advantageous Effects of Invention]

According to various embodiments of the disclosure, at the boundary between the flexible part and the rigid part, the side of the rigid insulating layer of the rigid part is recessed, thereby allowing the flexible part to be bent within the recessed portion. Hence, the bending moment applied to the flexible part is reduced, thereby reducing the risk of damage to the flexible part due to bending stress. In addition, the reduction in the area on the surface of the rigid part where the components can be mounted may be minimized or the area may be increased.

### [Brief Description of Drawings]

In connection with the description of the drawings, the same or similar reference symbols may be used for identical or similar components.
FIG. 1 is a block diagram of an exemplary electronic device capable of performing the operations described in this document.
FIGS. 2A, 2B, 2C, 2D, and 2E are diagrams illustrating an electronic device according to various embodiments of the disclosure.
FIG. 3 is a diagram illustrating the electronic device according to various embodiments of the disclosure.
FIG. 4A is a cross-sectional view showing the electronic device according to various embodiments of the disclosure.
FIG. 4B is a cross-sectional view showing the electronic device according to various embodiments of the disclosure.
FIG. 5A is a cross-sectional schematic diagram showing a rigid flexible printed circuit board according to various embodiments.
FIG. 5B is a cross-sectional schematic diagram showing a rigid flexible printed circuit board according to various embodiments.
FIG. 5C is a cross-sectional schematic diagram showing a rigid flexible printed circuit board according to various embodiments.
FIG. 5D is a cross-sectional schematic diagram showing a rigid flexible printed circuit board according to various embodiments.
FIGS. 6A to 6F are drawings showing operations for manufacturing a rigid flexible printed circuit board according to various embodiments.
FIGS. 7A and 7B are schematic diagrams showing operations for manufacturing a rigid flexible printed circuit board according to various embodiments.

### [Mode for the Invention]

Hereinafter, with reference to the drawings, embodiments of the disclosure will be described in detail so that those skilled in the art to which the disclosure pertains can easily carry out the disclosure. However, the disclosure may be implemented in various different forms and is not limited to those embodiments described herein. In connection with the description of the drawings, the same or similar reference symbols may be used for identical or similar components. Additionally, in the drawings and related descriptions, descriptions of well-known functions or configurations may be omitted for clarity and brevity.

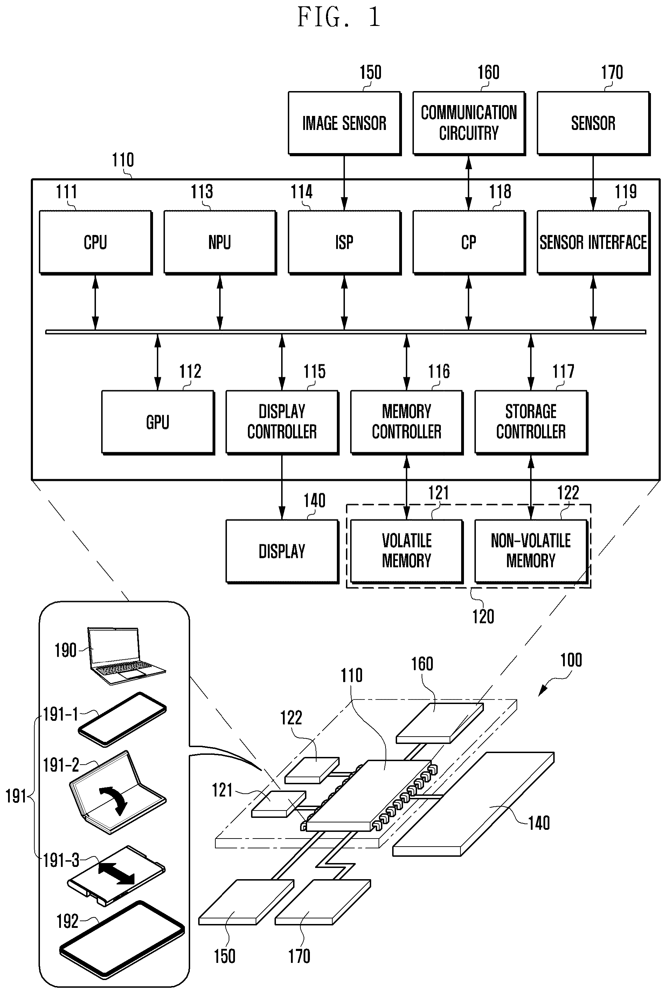

FIG. 1 is a block diagram of an exemplary electronic device 100 capable of executing the operations described in this document.

With reference to FIG. 1, the electronic device 100 may be one of various forms of electronic devices, such as a notebook 190, smartphones 191 having various form factors (e.g., bar-type smartphone 191-1, foldable-type smartphone 191-2, or slidable (or rollable) type smartphone 191-3, tablet 192, cellular phone (not shown), and other similar computing devices (not shown). The components, their relationships, and their functions depicted in FIG. 1 are illustrative only and do not limit the implementations described or claimed in this document. The electronic device 100 may be referred to as a mobile device, a user device, a multi-function device, a portable device, or a server.

The electronic device 100 may include components including at least one processor 110 (referred to as processor 110), at least one memory 120 (referred to as memory 120), at least one display 140 (referred to as display 140), at least one image sensor 150 (referred to as image sensor 150), at least one communication circuit 160 (referred to as communication circuit 160), and/or at least one sensor 170 (referred to as sensor 170). These components are merely illustrative. For example, the electronic device 100 may include other components (e.g., power management integrated circuitry (PMIC), audio processing circuitry, antenna, rechargeable battery, or input/output interface). For example, some of the components may be omitted from the electronic device 100. For example, some components may be combined into one component.

The processor 110 may be implemented with one or more IC (integrated circuit (or circuitry)) chips and may execute various data processing operations. The processor 110 may include at least one electrical circuit and may individually or collectively distribute and process instructions (or, programs, data) stored in the memory 120. The processor 110 may include a processor assembly composed of one or more processing circuits. The processor 110 may include any operative processing circuitry to control the performance and operations of one or more components of the electronic device 100 (e.g., memory 120, display 140, image sensor 150, communication circuit 160, and/or sensor 170). For example, the processor 110 (e.g., application processor (AP)) may be implemented as a system on chip (SoC) (e.g., single chip or chipset). For example, the processor 110 may be implemented with multiple cores (or, at least one core circuit), multiple chips, or multiple chipsets. For example, the processor 110 may include one or more processing circuits. For example, the processor 110 may include one or more processing circuits configured to individually and/or collectively perform various functions of the disclosure. As a non-limiting example, at least a portion of the processor 110 may be included in a first chip of the electronic device 100, and at least another portion of the processor 110 may be included in a second chip of the electronic device 100 that is different from the first chip of the electronic device 100.

For example, the processor 110 may include a central processing unit (CPU) 111, a graphics processing unit (GPU) 112, a neural processing unit (NPU) 113, an image signal processor (ISP) 114, a display controller 115, a memory controller 116, a storage controller 117, a communication processor (CP) 118, and/or a sensor interface 119. These components of the processor 110 are merely illustrative. For example, the processor 110 may further include other components. For example, some of the components of the processor 110 may be omitted from the processor 110. For example, some components of the processor 110 may be included as a separate component of the electronic device 100 outside the processor 110. For example, some components of the processor 110 (e.g., memory controller 116) may be included in other components (e.g., at least a portion of the memory 120, interface (e.g., available for connection to at least one component of the electronic device 100), display 140, and/or image sensor 150).

The processor 110 may cause other components of the electronic device 100 to perform various operations by executing instructions stored in the memory 120. The CPU 111 (or, central processing circuit) may be configured to control components of the processor 110 based on the execution of instructions stored in the memory 120 (e.g., volatile memory 121 and/or nonvolatile memory 122). The GPU 112 (or, graphics processing circuit) may be configured to execute parallel operations (e.g., rendering). The NPU 113 (or, neural processing circuit, AI (artificial intelligence) chip) may be configured to execute operations (e.g., convolution computation) for artificial intelligence models. The ISP 114 (or, image signal processing circuit) may be configured to process a raw image obtained through the image sensor 150 into a format suitable for a component within the electronic device 100 or a component of the processor 110. The display controller 115 (or, display control circuit, display processing unit (DPU)) may be configured to process images obtained from the CPU 111, GPU 112, ISP 114, or memory 120 (e.g., volatile memory 121) into a format suitable for the display 140. The memory controller 116 (or, memory control circuit) may be configured to control reading data from the volatile memory 121 and writing data to the volatile memory 121. The storage controller 117 (or, storage control circuit) may be configured to control reading data from the nonvolatile memory 122 and writing data to the nonvolatile memory 122. The CP 118 (or, communication processing circuit) may be configured to process data obtained from a component of the processor 110 into a format suitable for transmitting to another electronic device through the communication circuit 160, or to process data obtained from another electronic device through the communication circuit 160 into a format suitable for processing of a component of the processor 110. For example, the communication circuit 160 may include one or more communication circuits. The sensor interface 119 (or, sensing data processing circuit, sensor hub) may be configured to process data on the status of the electronic device 100 and/or the status of the surroundings of the electronic device 100, obtained through the sensor 170, into a format suitable for a component of the processor 110.

The memory 120 may include one or more storage media (or, one or more storage devices). For example, the memory 120 may include a memory assembly including one or more storage media. For example, the one or more storage media may include a permanent memory (e.g., nonvolatile memory 122), such as a hard drive, flash memory, read-only memory (ROM), a semi-permanent memory (e.g., volatile memory 121), such as random access memory (RAM), any other suitable type of storage (or, storage assembly), or any combination thereof. The memory 120 may include a cache memory, which is one or more different types of memory used to temporarily store data for the function or feature of the electronic device 100. As a non-limiting example, the cache memory may be included in the processor 110. The memory 120 may be fixedly embedded in the electronic device 100 or incorporated into one or more suitable types of components (e.g., subscriber identity module (SIM) card and/or secure digital (SD) card) that can be repeatedly inserted into and removed from the electronic device 100.

For example, the memory 120 may store one or more software applications, such as operating system (or system) software applications, firmware software applications, driver software applications, plug-in (e.g., add-in, add-on, and/or applet) software applications, and/or any other suitable software applications. For example, the one or more software applications may include instructions executable by the processor 110. For example, the memory 120 may store instructions that can be invoked by an application programming interface (API). For example, the memory 120 may store instructions within a library.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

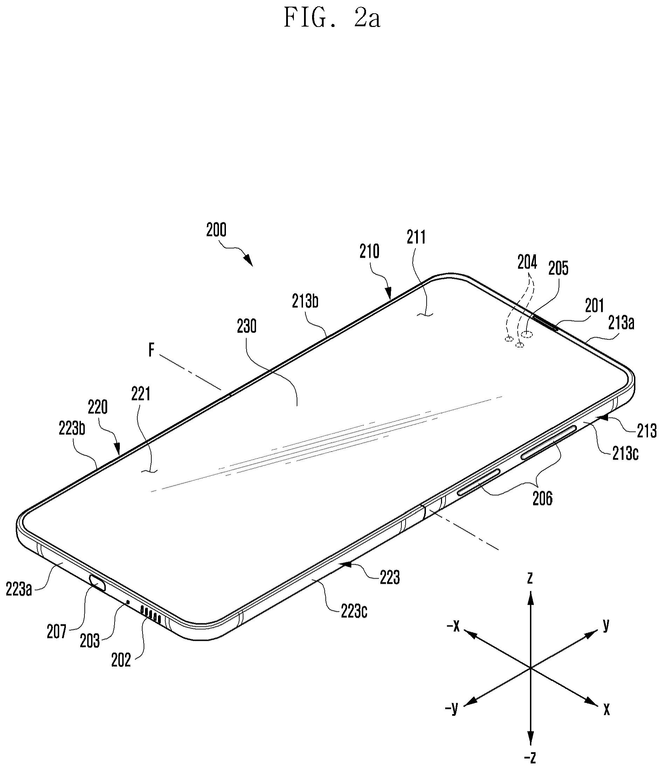

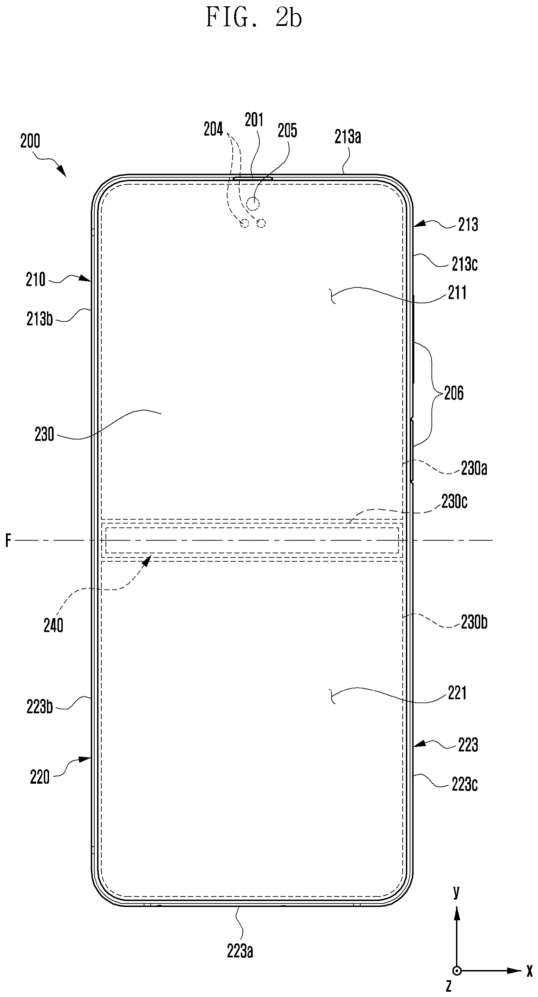

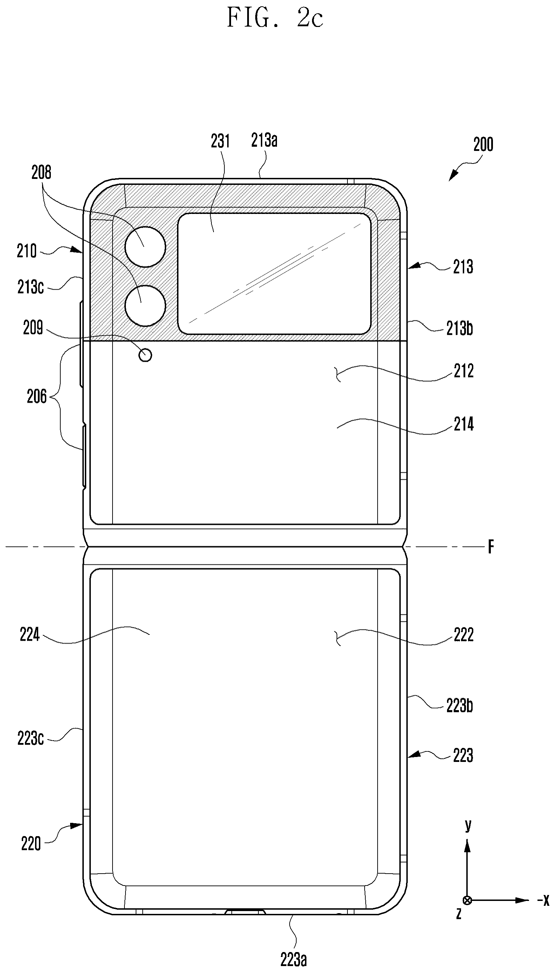

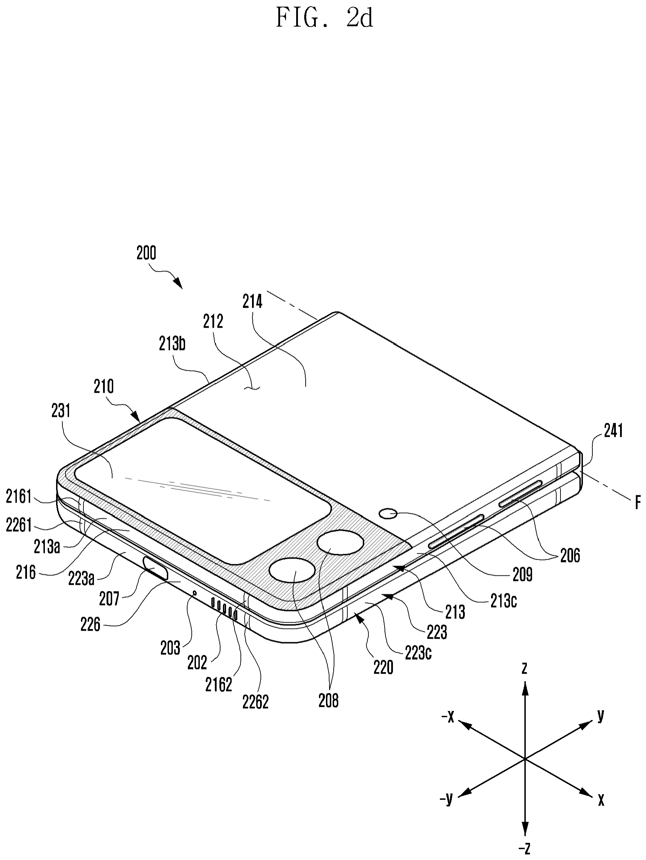

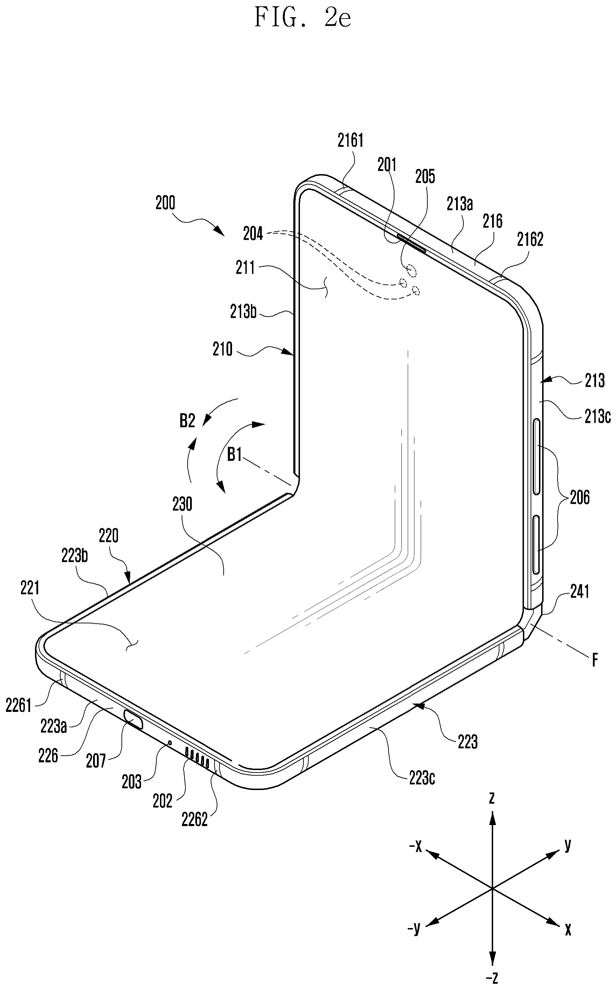

FIGS. 2A, 2B, 2C, 2D, and 2E are diagrams illustrating an electronic device 200 according to various embodiments of the disclosure.

FIG. 2A is a perspective view of an electronic device in flat or unfolded state according to various embodiments of the disclosure. FIG. 2B is a plan view illustrating the front of the electronic device in unfolded state according to an embodiment of the disclosure. FIG. 2C is a plan view illustrating the back of the electronic device in unfolded state according to an embodiment of the disclosure. FIG. 2D is a perspective view of the electronic device in folded state according to an embodiment of the disclosure. FIG. 2E is a perspective view of the electronic device in intermediate state according to an embodiment of the disclosure.

With reference to FIGS. 2A to 2E, the electronic device 200 may include first and second housings 210 and 220 (e.g., foldable housing structure) that are foldably coupled to each other relative to a hinge mechanism (e.g., hinge mechanism 240 in FIG. 2B). In an embodiment, the hinge mechanism (e.g., hinge mechanism 240 in FIG. 2B) may be disposed in the X-axis direction or in the Y-axis direction. In an embodiment, the electronic device 200 may include a first display 230 (e.g., flexible display, foldable display, or main display) disposed in an area (e.g., recession) formed by the first and second housings 210 and 220. In an embodiment, the first housing 210 and the second housing 220 may be disposed on both sides about the folding axis (F), and may have a substantially symmetrical shape with respect to the folding axis (F). In an embodiment, the angle or distance between the first housing 210 and the second housing 220 may vary depending on the state of the electronic device 200. For example, the angle or distance between the first housing 210 and the second housing 220 may vary depending on whether the state of the electronic device 200 is a flat or unfolded state, a folded state, or an intermediate state.

In an embodiment, in the unfolded state of the electronic device 200, the first housing 210 may include a first surface 211 facing in a first direction (e.g., front direction) (z-axis direction), and a second surface 212 facing in a second direction (e.g., rear direction) (negative z-axis direction) opposite to the first surface 211. In an embodiment, in the unfolded state of the electronic device 200, the second housing 220 may include a third surface 221 facing in the first direction (z-axis direction), and a fourth surface 222 facing in the second direction (negative z-axis direction). In an embodiment, in the unfolded state of the electronic device 200, the first surface 211 of the first housing 210 and the third surface 221 of the second housing 220 may face in substantially the same first direction (z-axis direction). In an embodiment, in the folded state of the electronic device 200, the first side surface 211 of the first housing 210 and the third surface 221 of the second housing 220 may face each other. In an embodiment, in the unfolded state of the electronic device 200, the second surface 212 of the first housing 210 and the fourth surface 222 of the second housing 220 may face in substantially the same second direction (negative z-axis direction). In an embodiment, in the folded state of the electronic device 200, the second surface 212 of the first housing and the fourth surface 222 of the second housing 220 may face in opposite directions. For example, in the folded state of the electronic device 200, the second surface 212 may face in the first direction (z-axis direction) and the fourth surface 222 may face in the second direction (negative z-axis direction). In this case, the first display 230 may be not visible from the outside (in-folding scheme). In an embodiment, the electronic device 200 may be folded so that the second surface 212 of the first housing 210 and the fourth surface 222 of the second housing 220 face each other. In this case, the first display 230 may be disposed to be visible from the outside (out-folding scheme).

According to an embodiment, the first housing 210 (e.g., first housing structure) may include a first lateral member 213 that at least partially constitutes the external appearance of the electronic device 200, and a first rear cover 214 coupled to the first lateral member 213 and constituting at least a portion of the second surface 212 of the electronic device 200. In an embodiment, the first lateral member 213 may include a first side surface 213a, a second side surface 213b extending from one end of the first side surface 213a, and a third side surface 213c extending from the other end of the first side surface 213a. In an embodiment, the first lateral member 213 may be formed in a rectangular shape (e.g., square or rectangle) through the first side surface 213a, second side surface 213b, and third side surface 213c.

According to an embodiment, the second housing 220 (e.g., second housing structure) may include a second lateral member 223 that at least partially constitutes the external appearance of the electronic device 200, and a second rear cover 224 coupled to the second lateral member 223 and constituting at least a portion of the fourth surface 222 of the electronic device 200. In an embodiment, the second lateral member 223 may include a fourth side surface 223a, a fifth side surface 223b extending from one end of the fourth side surface 223a, and a sixth side surface 223c extending from the other end of the fourth side surface 223a. In an embodiment, the second lateral member 223 may be formed in a rectangular shape through the fourth side surface 223a, fifth side surface 223b, and sixth side surface 223c.

According to an embodiment, the first and second housings 210 and 220 are not limited to the illustrated shape and combination, and may be implemented with a combination of other shapes or parts. In an embodiment, the first lateral member 213 may be integrally formed with the first rear cover 214, and the second lateral member 223 may be integrally formed with the second rear cover 224.

According to an embodiment, in the unfolded state of the electronic device 200, the second side surface 213b of the first lateral member 213 and the fifth side surface 223b of the second lateral member 223 may be connected without a gap. In an embodiment, in the unfolded state of the electronic device 200, the third side surface 213c of the first lateral member 213 and the sixth side surface 223c of the second lateral member 223 may be connected without a gap. In an embodiment, in the unfolded state of the electronic device 200, the combined length of the second side surface 213b and the fifth side surface 223b may be formed to be longer than the length of the first side surface 213a and/or the fourth side surface 223a. In an embodiment, in the unfolded state of the electronic device 200, the combined length of the third side surface 213c and the sixth side surface 223c may be formed to be longer than the length of the first side surface 213a and/or the fourth side surface 223a.

With reference to FIGS. 2D and 2E, the first lateral member 213 and/or the second lateral member 223 may be made of a metal or may further include a polymer injected into the metal. In an embodiment, the first lateral member 213 and/or the second lateral member 223 may include at least one conductive part 216 and/or 226 electrically separated through one or more cut-off portions 2161 and 2162 and/or 2261 and 2262 made of a polymer. In this case, the at least one conductive part 216 and/or 226 may be electrically connected to a wireless communication circuit included in the electronic device 200 and may be used as at least a part of an antenna operating in at least one designated band (e.g., legacy band).

According to an embodiment, the first rear cover 214 and/or the second rear cover 224 may be made of, for example, coated or tinted glass, ceramic, polymer, metal (e.g., aluminum, stainless steel (STS), or magnesium), or a combination thereof.

According to an embodiment, the first display 230 may be disposed to extend from the first surface 211 of the first housing 210 across the hinge mechanism (e.g., hinge mechanism 240 in FIG. 2B) to at least a portion of the third surface 221 of the second housing 220. In an embodiment, the first display 230 may include a first region 230a substantially corresponding to the first surface 211, a second region 230b corresponding to the second surface 221, and a third region 230c (e.g., bendable region or folding region) connecting the first region 230a and the second region 230b. In an embodiment, the third region 230c may be disposed as part of the first region 230a and/or the second region 230b at a position corresponding to the hinge mechanism (e.g., hinge mechanism 240 in FIG. 2B). In an embodiment, the electronic device 200 may include a hinge housing 241 (e.g., hinge cover) that supports the hinge mechanism (e.g., hinge mechanism 240 in FIG. 2B). In an embodiment, the hinge housing 241 may be disposed so as to be exposed to the outside when the electronic device 200 is in the folded state, and be invisible from the outside by being slid into the internal space of the first housing 210 and the internal space of the second housing 220 when the electronic device 200 is in the unfolded state.

According to an embodiment, the electronic device 200 may include a second display 231 (e.g., sub-display) disposed separately from the first display 230. In an embodiment, the second display 231 may be disposed to be at least partially exposed on the second surface 212 of the first housing 210. In an embodiment, when the electronic device 200 is in the folded state, the second display 231 may display at least some of the state information about the electronic device 200 in place of at least some of the display function of the first display 230. In an embodiment, the second display 231 may be disposed to be visible from the outside through at least some region of the first rear cover 214. In an embodiment, the second display 231 may be disposed on the fourth surface 222 of the second housing 220. In this case, the second display 231 may be disposed to be visible from the outside through at least some region of the second rear cover 224.

According to an embodiment, the electronic device 200 may include at least one of an input device 203 (e.g., microphone), sound output devices 201 and 202, a sensor module 204, camera devices 205 and 208, a key input device 206, or a connector port 207. In the illustrated embodiment, the input device 203 (e.g., microphone), sound output devices 201 and 202, sensor module 204, camera devices 205 and 208, key input device 206, and connector port 207 are indicated as a hole or circle shape formed in the first housing 210 or the second housing 220, but this representation is illustrative only for description without being limited thereto. According to an embodiment, the input device 203 may include at least one microphone 203 disposed on the second housing 220. In an embodiment, the input device 203 may include a plurality of microphones 203 disposed to detect the direction of a sound. In an embodiment, the plural microphones 203 may be disposed at appropriate positions in the first housing 210 and/or the second housing 220. In an embodiment, the sound output devices 201 and 202 may include one or more speakers 201 and 202. In an embodiment, the one or more speakers 201 and 202 may include a call receiver 201 disposed in the first housing 210, and a speaker 202 disposed in the second housing 220. In an embodiment, the input device 203, the sound output devices 201 and 202, and the connector port 207 may be disposed in a space arranged in the first housing 210 and/or the second housing 220 of the electronic device 200, and may be exposed to the external environment through at least one hole formed in the first housing 210 and/or the second housing 220. In an embodiment, at least one connector port 207 may be used to transmit and receive power and/or data to and from an external electronic device. In an embodiment, at least one connector port (e.g., ear jack hole) may accommodate a connector (e.g., ear jack) for transmitting and receiving an audio signal to and from an external electronic device. In an embodiment, the hole formed in the first housing 210 and/or the second housing 220 may be commonly used for the input device 203 and the sound output devices 201 and 202. In an embodiment, the sound output devices 201 and 202 may include a speaker (e.g., piezo speaker) that is not exposed through the hole formed in the first housing 210 and/or the second housing 220.

According to an embodiment, the sensor module 204 may generate an electrical signal or data value corresponding to an internal operating state of the electronic device 200 or an external environmental state. In an embodiment, the sensor module 204 may detect an external environment through the first surface 211 of the first housing 210. In an embodiment, the electronic device 200 may further include at least one sensor module disposed to detect an external environment through the second surface 212 of the first housing 210. In an embodiment, the sensor module 204 (e.g., illuminance sensor) may be disposed under the first display 230 to detect an external environment through the first display 230. In an embodiment, the sensor module 204 may include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, an illuminance sensor, a proximity sensor, a biometric sensor, an ultrasonic sensor, or an illuminance sensor 204.

According to an embodiment, the camera devices 205 and 208 may include a first camera device 205 (e.g., front camera device) disposed on the first surface 211 of the first housing 210, and a second camera device 208 disposed on the second surface 212 of the first housing 210. In an embodiment, the electronic device 200 may further include a flash 209 disposed close to the second camera device 208. In an embodiment, the camera device 205 or 208 may include one or more lenses, an image sensor, and/or an image signal processor. In an embodiment, the camera devices 205 and 208 may be arranged so that two or more lenses (e.g., wide-angle lens, super-wide-angle lens, or telephoto lens) and two or more image sensors are positioned on one surface (e.g., first surface 211, second surface 212, third surface 221, or fourth surface 222) of the electronic device 200. In an embodiment, the camera devices 205 and 208 may include time-of-flight (TOF) lenses and/or an image sensor.

According to an embodiment, the key input device 206 (e.g., key button) may be disposed on the third side surface 213c of the first lateral member 213 of the first housing 210. In an embodiment, the key input device 206 may be disposed on at least one of the other side surfaces 213a and 213b of the first housing 210 and/or the side surfaces 223a, 223b and 223c of the second housing 220. In an embodiment, the electronic device 200 may not include some or all of the key input devices 206, and those not included key input devices 206 may be implemented in other forms, such as soft keys, on the first display 230. In an embodiment, the key input device 206 may be implemented by using a pressure sensor included in the first display 230.

According to an embodiment, some of the camera devices 205 and 208 (e.g., first camera device 205) or the sensor module 204 may be disposed to be exposed through the first display 230. In an embodiment, the first camera device 205 or the sensor module 204 may be arranged in the internal space of the electronic device 200 so as to be optically exposed to the outside through an opening (e.g., through hole) formed at least partially in the first display 230. In an embodiment, some sensor modules 204 may be arranged in the internal space of the electronic device 200 so as not to be visually exposed through the first display 230. With reference to FIG. 2B, the electronic device 200 may be operated to maintain at least one designated folding angle in the intermediate state through the hinge mechanism (e.g., hinge mechanism 240 in FIG. 2B). In this case, the electronic device 200 may control the first display 230 to display different pieces of content on the display area corresponding to the first surface 211 and the display area corresponding to the third surface 221. In an embodiment, the electronic device 200 may be operated substantially in an unfolded state (e.g., unfolded state of FIG. 2A) and/or substantially in a folded state (e.g., folded state of FIG. 2A) through the hinge mechanism (e.g., hinge mechanism 240 in FIG. 2B) with respect to a specific folding angle (e.g., angle between the first housing 210 and the second housing 220 in the intermediate state of the electronic device 200). In an embodiment, when a pressing force is applied in the unfolding direction (B1 direction) in a state where the electronic device 200 is unfolded at a specific folding angle, through the hinge mechanism (e.g., hinge mechanism 240 in FIG. 2B), the electronic device 200 may be operated to transition to the unfolded state (e.g., unfolded state of FIG. 2A). In an embodiment, when a pressing force is applied in the folding direction (B2 direction) in a state where the electronic device 200 is unfolded at a specific folding angle, through the hinge mechanism (e.g., hinge mechanism 240 in FIG. 2B), the electronic device 200 may be operated to transition to the folded state (e.g., folded state of FIG. 2D). In an embodiment, the electronic device 200 may be operated to remain in the unfolded state at various angles (not shown) through the hinge mechanism (e.g., hinge mechanism 240 in FIG. 2B) (free-stop feature).

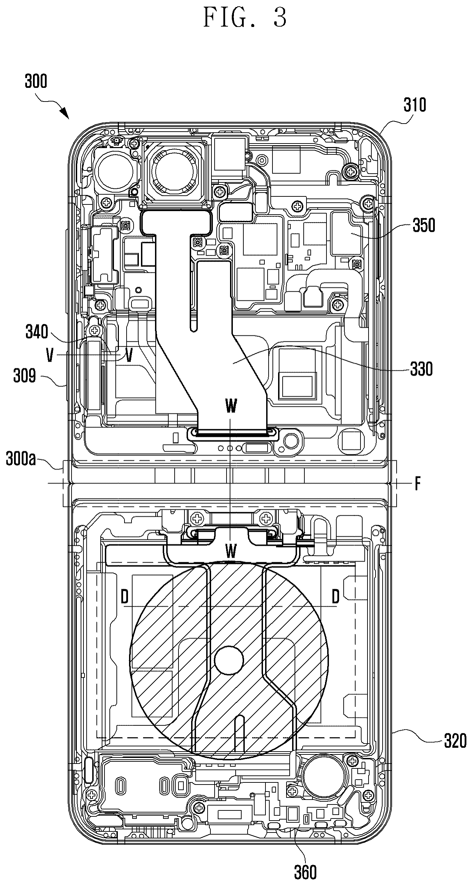

FIG. 3 is a diagram showing an electronic device 300 according to various embodiments of the disclosure.

With reference to FIG. 3, the electronic device 300 according to various embodiments of the disclosure (e.g., electronic device 101 in FIG. 1, electronic device 200 in FIGS. 2A to 2E) may include a first housing 310, a second housing 320, a rigid flexible printed circuit board 401 (e.g., first rigid flexible printed circuit board 330 and second rigid flexible printed circuit board 340), a first printed circuit board 350, and/or a second printed circuit board 360. The electronic device 300 may be a foldable type device. The first housing 310 and the second housing 320 may be foldably coupled to each other with respect to the folding axis (F).

In various embodiments, the electronic device 300 may include a folding region 300a positioned between the first housing 310 and the second housing 320. A hinge that enables the first housing 310 and the second housing 320 to rotate may be positioned in the folding region 300a. The first housing 310 and the second housing 320 may be rotatably connected to each other through the hinge.

In various embodiments, the first printed circuit board 350 may be disposed in the first housing 310. The second printed circuit board 360 may be disposed in the second housing 320.

In various embodiments, the processor (110, see FIG. 1) and/or the memory (120, see FIG. 1) may be disposed on the first printed circuit board 350 and/or the second printed circuit board 360. The processor (110, see FIG. 1) may include a main processor (111, see FIG. 1) (e.g., central processing unit or processor) or auxiliary processors (112 to 119, see FIG. 1) (e.g., graphics processing unit, neural processing unit (NPU), image signal processor, sensor hub processor, or communication processor), which may operate independently of or together with the main processor (111, see FIG. 1). The memory (120, see FIG. 1) may include a volatile memory (121, see FIG. 1) or a non-volatile memory (122, see FIG. 1).

In various embodiments, the first rigid flexible printed circuit board 330 may be disposed in the first housing 310 and the second housing 320. The first rigid flexible printed circuit board 330 may be extended from the first housing 310 through the folding region 300a toward the second housing 320.

In various embodiments, one end of the first rigid flexible printed circuit board 330 may be connected to the first printed circuit board 350, and the other end of the first rigid flexible printed circuit board 330 may be connected to the second printed circuit board 360. The first rigid flexible printed circuit board 330 may electrically connect the first printed circuit board 350 and the second printed circuit board 360.

In various embodiments, the second rigid flexible printed circuit board 340 may be disposed in the first housing 310. The second rigid flexible printed circuit board 340 may be a member that electrically connects various electrical components such as the key member (309) and the first printed circuit board 350. In various embodiments, the second rigid flexible printed circuit board 340 may be a member on which various electrical components are disposed to assist in transmitting an input signal of the first key member 309 to a component (e.g., processor 110 in FIG. 1) disposed on the first printed circuit board 350.

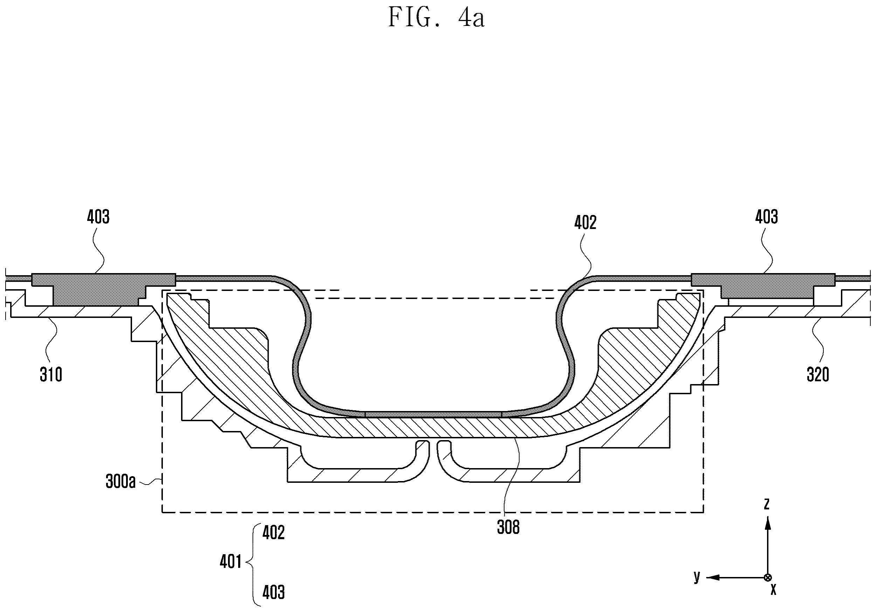

FIG. 4A is a cross-sectional view showing an electronic device according to various embodiments of the disclosure.

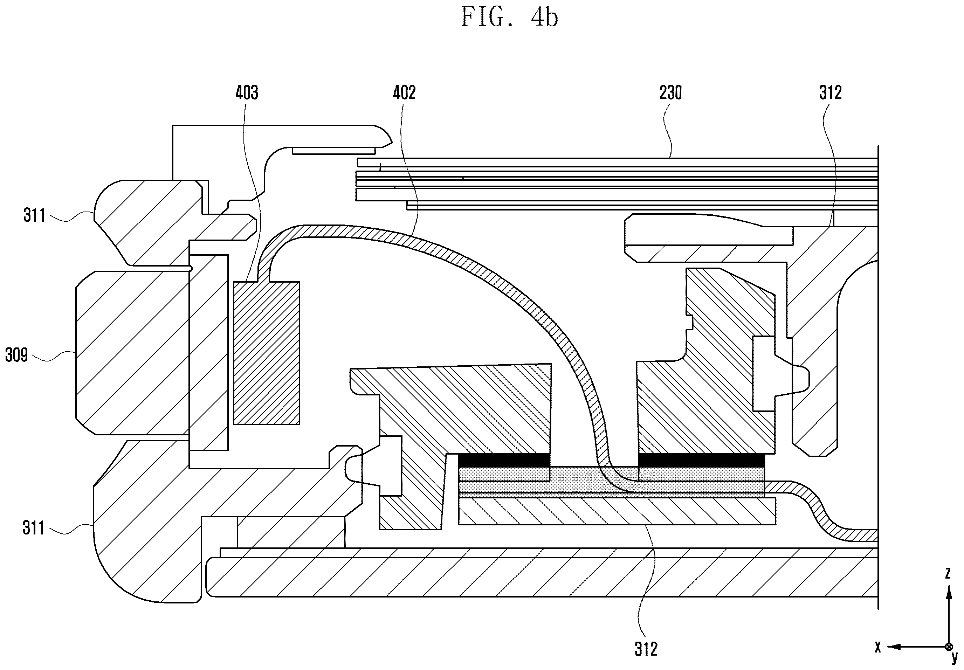

FIG. 4B is a cross-sectional view showing an electronic device according to various embodiments of the disclosure.

FIG. 4A illustrates a cross-section along the W-W direction in FIG. 3, and FIG. 4B illustrates a cross-section along the V-V direction in FIG. 3. In FIG. 4A, some parts are omitted for clarity.

With reference to FIGS. 4A and 4B, the electronic device (e.g., electronic device 100 in FIG. 1, electronic device 200 in FIGS. 2A to 2E, and electronic device 300 in FIG. 3) according to various embodiments may include a rigid flexible printed circuit board 401. The rigid flexible printed circuit board 401 may include a rigid part 403 (or, rigid portion) and a flexible part 402 (or, flexible portion). The rigid part 403 may be a portion having relatively high rigidity compared to the flexible part 402 to be described later. The rigid part 403 may be a portion that provides a surface on which various electrical components (e.g., elements such as a resistor, chip capacitor, chip inductor, PMIC, and/or analog to digital converter (ADC)) are disposed.

The flexible part 402 may be disposed in a bent state within the electronic device, or may be disposed to bend due to a change in the shape of the electronic device (e.g., folding and unfolding operations of the foldable electronic device).

In various embodiments, the electronic device may include a hinge housing 308 that protects the folding region 300a. The flexible part 402 of the rigid flexible printed circuit board 401 may be extended from the first housing 310 through the interior of the hinge housing 308 to the second housing 320. The rigid part 403 of the rigid flexible printed circuit board 401 may be disposed in the first housing 310 and/or the second housing 320.

In various embodiments, the electronic device may include a key member 309. The housing (e.g., first housing 310) of the electronic device may include a side frame 311 covering the side surface (e.g., surface in x-direction and/or surface in negative x-direction) of the electronic device, and an internal frame 312 coupled with the side frame 311 and supporting components of the electronic device in the front direction (e.g., z-direction) within the electronic device. The key member 309 may be exposed to the side surface of the electronic device through an opening formed in the side frame 311. In various embodiments, the key member 309 may be a fingerprint key integrated with a sensor (e.g., fingerprint recognition sensor). In various embodiments, the key member 309 may be configured to be integrated with a haptic module to provide haptic feedback to the user. In various embodiments, the key member 309 may be a volume key for adjusting the volume of the electronic device, a power key for controlling the power of the electronic device and turning the screen on/off, and/or a function key for invoking various functions such as voice recognition AI (artificial intelligence). Additionally, in various embodiments, the electronic device may include various components (as a non-limiting example, antenna module, haptic module, microphone, speaker, and/or wired connection terminal) disposed to face the side surface of the housing.

In various embodiments, the key member 309 may be disposed on the rigid part 403 of the rigid flexible printed circuit board 401. The rigid part 403 of the rigid flexible printed circuit board 401 may be oriented so that one surface faces in the same direction as the orientation direction of the key member 309. For example, the rigid part 403 may be disposed substantially parallel to the side frame 311. The flexible part 402 of the rigid flexible printed circuit board may be extended from the rigid part 403 and bent so that one surface thereof becomes substantially parallel to the internal frame 312. To reduce the thickness (z-axis dimension) of the electronic device, the bending of the flexible part 402 may need to be steeper (e.g., the flexible part 402 may need to be bent to have a smaller radius of curvature). In various embodiments, various components disposed to face the side surface of the housing (as a non-limiting example, antenna module, haptic module, microphone, speaker, and/or wired connection terminal) may be arranged on the rigid part 403 of the rigid flexible printed circuit board 401.

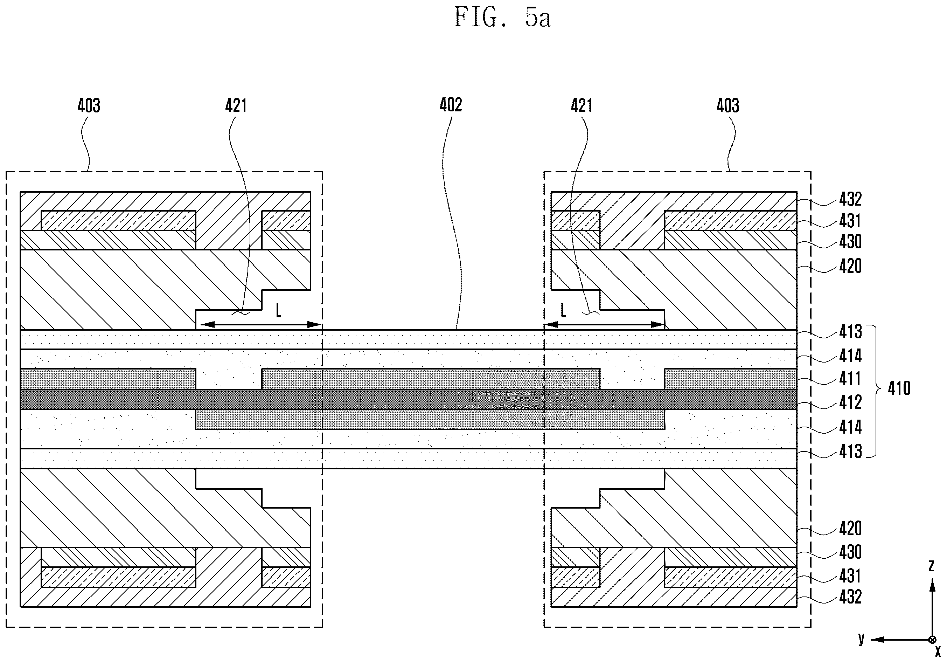

FIG. 5A is a cross-sectional schematic diagram showing the rigid flexible printed circuit board 401 according to various embodiments.

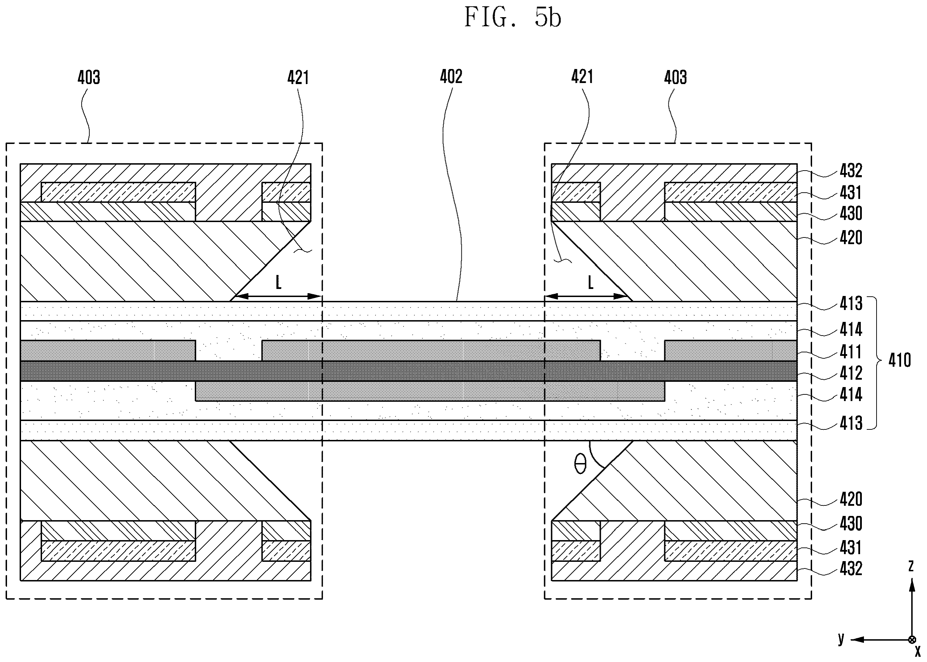

FIG. 5B is a cross-sectional schematic diagram showing the rigid flexible printed circuit board 401 according to various embodiments.

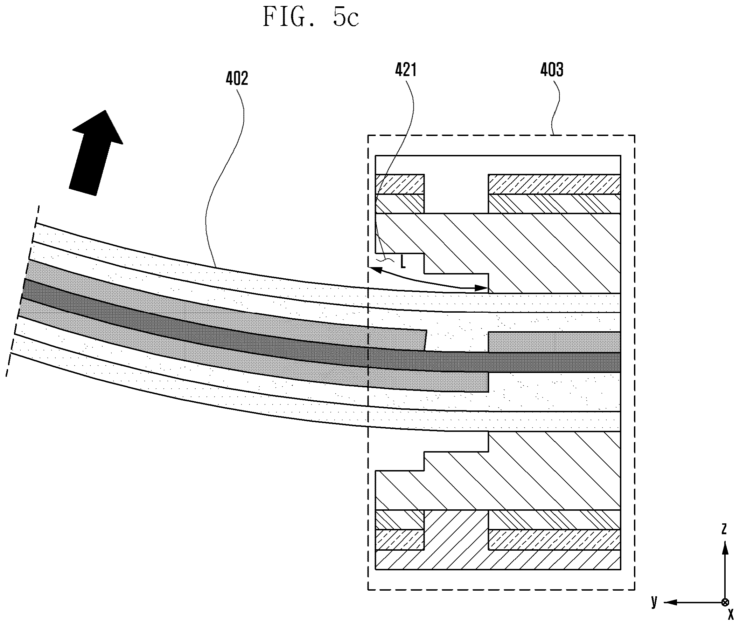

FIG. 5C is a cross-sectional schematic diagram showing the rigid flexible printed circuit board 401 according to various embodiments.

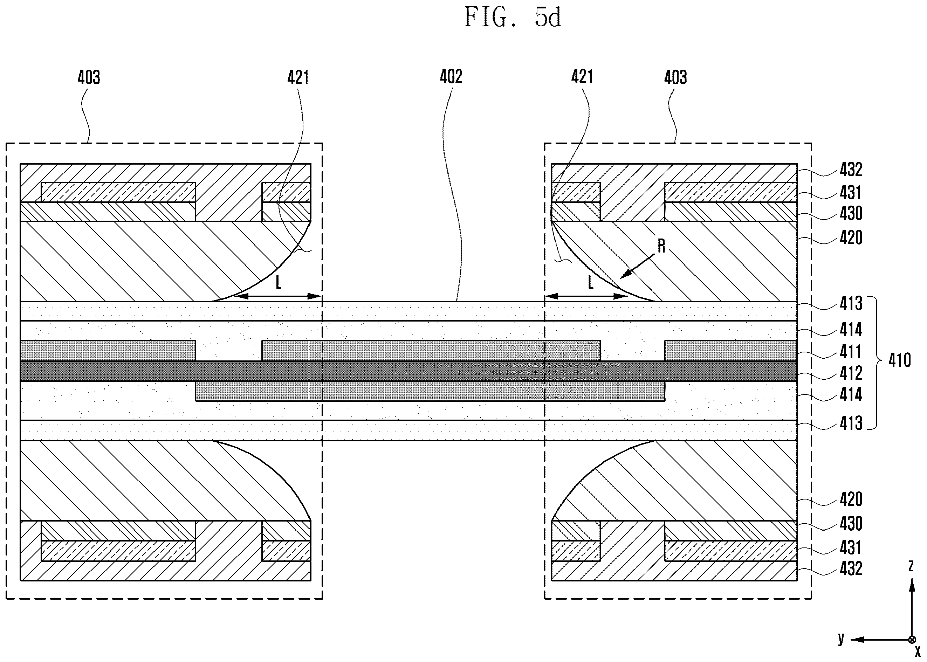

FIG. 5D is a cross-sectional schematic diagram showing the rigid flexible printed circuit board 401 according to various embodiments.

With reference to FIGS. 5A and 5B, the rigid flexible printed circuit board 401 according to various embodiments of the disclosure may include a flexible substrate layer 410. The flexible substrate layer 410 may be positioned in the flexible part 402 and the rigid part 403. The flexible substrate layer 410 may include at least one flexible conductor layer 411 and a flexible insulating layer 412 having a ductile non-conductive material (e.g., polyimide film). In various embodiments, a coverlay layer 413, and a coverlay adhesive layer 414 that adheres the coverlay layer 413 to the flexible conductor layer 411 and the flexible insulating layer 412 may be positioned on the flexible conductor layer 411. In various embodiments, the flexible substrate layer 410 may be a laminated structure of at least one single-sided FCCL (flexible copper clad laminate) and/or double-sided FCCL. The flexible part 402 of the rigid flexible printed circuit board 401 may be a portion made of the flexible substrate layer 410.

In various embodiments, the rigid flexible printed circuit board 401 may include a rigid insulating layer 420. The rigid insulating layer 420 may be positioned in the rigid part 403 of the rigid flexible printed circuit board 401. The rigid insulating layer 420 may include, for example, a rigid resin matrix, and a reinforcing material (e.g., inorganic particles and/or fibers) dispersed in the rigid resin matrix. In various embodiments, the rigid insulating layer 420 may be formed by curing a prepreg in which a reinforcing material and a resin are mixed.

In various embodiments, the rigid insulating layer 420 may include a recessed portion 421. The recessed portion 421 may be a portion formed by recessing the side surface of the rigid insulating layer 420 at the boundary between the flexible part 402 and the rigid part 403.

In various embodiments, the invagination distance of the recessed portion 421 may increase as it approaches the flexible substrate layer 410 with respect to the thickness direction (z-axis direction) of the rigid flexible printed circuit board 401. For example, as shown in FIG. 5A, the recessed portion 421 may have a step shape in which the invagination distance in the side direction (e.g., y-axis direction in FIGS. 5A to 5C) of the rigid insulating layer increases stepwise as it approaches the flexible substrate layer 410 with respect to the thickness direction (z-axis direction). In addition, for example, as shown in FIG. 5B, the recessed portion 421 may have an inclined shape in which the invagination distance continuously increases as it approaches the flexible substrate layer 410. For example, at the boundary between the rigid part 403 and the flexible part 402, the side surface of the rigid insulating layer 420 may form an acute angle (θ) smaller than a right angle.

In various embodiments, a conductor layer 430 and a cover layer 432 (e.g., photo solder resist (PSR) layer) may be disposed on the rigid insulating layer 420. The conductor layer 430 may be electrically connected to various electrical components (e.g., key switch, resistor, chip capacitor, chip inductor, PMIC, and/or ADC) arranged on the rigid insulating layer 420. In various embodiments, one or more conductor layers 430 may be stacked on the rigid insulating layer 420. In various embodiments, a base layer of a non-conductive material (e.g., polyimide) may be stacked on each conductor layer 430 on the rigid insulating layer 420.

With reference to FIG. 5C, when bending is applied to the flexible part 402 of the rigid flexible printed circuit board 401, the bending moment may be dispersed in the length direction (e.g., y direction) of the flexible part 402. According to embodiments of the disclosure, the length of the bendable region of the flexible substrate layer 410 is increased by the invagination distance (L) of the recessed portion 421, and thus the bending moment may be distributed over a wider range, thereby reducing the stress applied to the flexible substrate layer 410. Hence, the risk of damage to the rigid flexible printed circuit board 401 may be reduced. In addition, the risk of cracking of the flexible conductor layer 411 caused by stress concentration at the boundary between the rigid part 403 and the flexible part 402 may be reduced.

Additionally, in various recessed portions 421, the distance (L) at which the side surface of the rigid insulating layer 420 is recessed in the side direction (e.g., y-axis direction in FIGS. 5A to 5C) decreases as it gets farther away from the flexible substrate layer 410 with respect to the thickness direction (z-axis direction), the area of the upper surface (surface on which the conductor layer 430 is stacked) of the rigid insulating layer 420 may be wider than that of the lower surface (surface in contact with the flexible substrate layer 410). Consequently, according to the disclosure, a sufficient length for dispersing the stress of the flexible substrate layer may be secured, and an area for stacking a conductor layer on the rigid insulating layer 420 and arranging various electrical components may be secured.

With reference to FIG. 5D, in various embodiments, the inner surface of the recessed portion 421 may have a curved shape. For example, the invagination depth (L) of the recessed portion may be continuously changed so that the side surface of the rigid insulating layer 420 has a curvature (R). The curvature (R) of the inner surface of the recessed portion may have a constant value and/or may vary. The inner surface of the recessed portion may have a shape such as an arc, an ellipse, a parabola, and/or a hyperbola. Since the side surface of the rigid insulating layer 420 has a curved shape, the stress may be effectively distributed over a wide range when the flexible substrate layer 410 is bent. In various embodiments, the shape of the recessed portion 421 may be formed such that, at a portion where the side surface of the rigid insulating layer 420 and the surface of the flexible substrate layer 410 come into contact, the tangent line of the side surface of the rigid insulating layer 420 is substantially parallel to the surface of the flexible substrate layer 410. Hence, the stress received by the flexible substrate layer 410 may be dispersed at the portion where the side surface of the rigid insulating layer 420 and the surface of the flexible substrate layer 410 come into contact with each other.

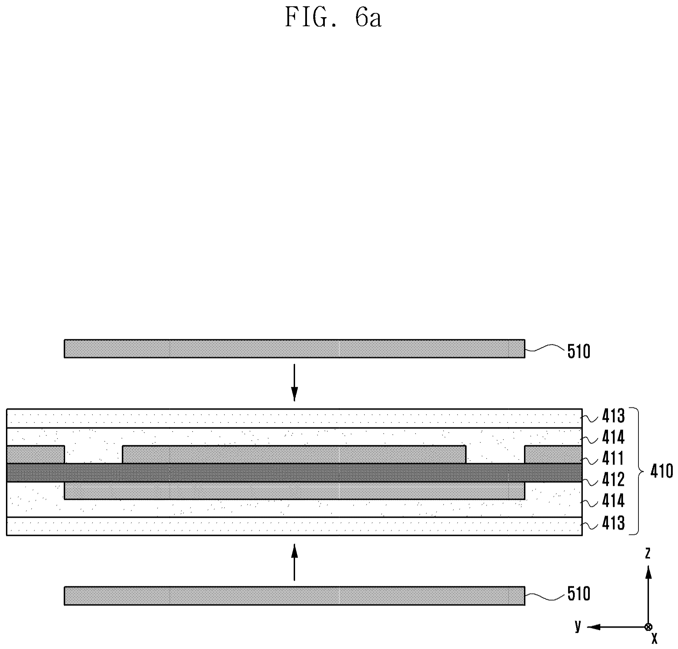

FIGS. 6A to 6F are diagrams illustrating operations for manufacturing a rigid flexible printed circuit board 401 according to various embodiments.

With reference to FIG. 6A, to manufacture the rigid flexible printed circuit board 401, an operation of stacking a release film 510 (e.g., first release film 511) on the flexible substrate layer 410 may be performed. The flexible substrate layer 410 may be a flexible circuit board in which a circuit is formed on FCCL by a means such as etching and a coverlay layer 413 is stacked. The release film 510 may be a film made of a polymer material such as polyethylene, polypropylene, polyolefin, polyethylene terephthalate, polystyrene, and/or polyvinyl alcohol.

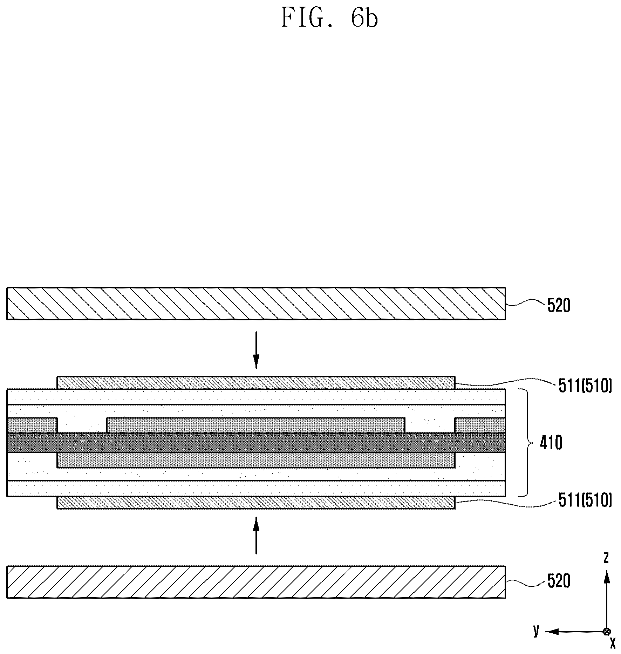

With reference to FIG. 6B, a prepreg 520 may be stacked on the flexible substrate layer 410 on which the release film 510 is stacked. The prepreg 520 may be obtained by impregnating a filler (may include, e.g., inorganic particles, fibers (polymer fibers and/or glass fibers) and/or fabrics) with a resin. When cured, the prepreg 520 may form the rigid insulating layer 420 of the rigid flexible printed circuit board 401.

In various embodiments, the operation of stacking the prepreg 520 may additionally include an operation of pressurizing the prepreg 520 after laminating the prepreg 520. Additionally, in various embodiments, the operation of stacking the prepreg 520 may additionally include an operation of removing the prepreg 520 on the release film 510 after stacking the prepreg 520. Removal of the prepreg 520 may be performed by means such as cutting with a blade.

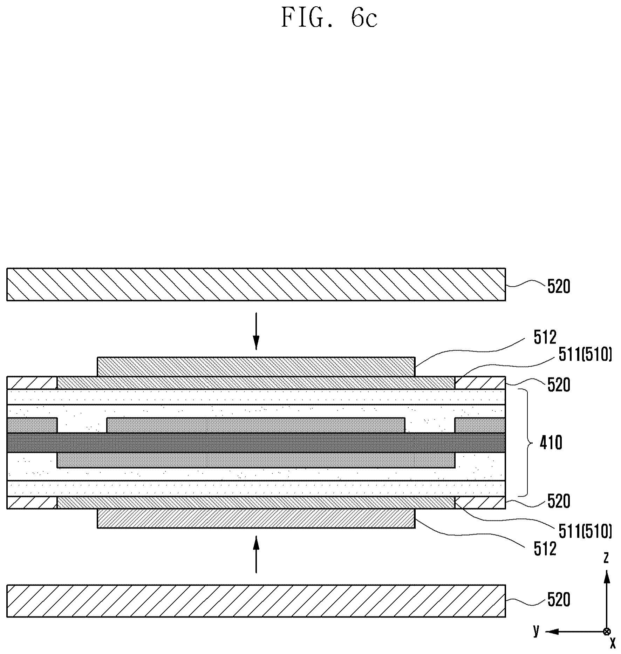

With reference to FIG. 6C, a second release film 512 may be additionally stacked on the release film 510 (e.g., first release film 511). The second release film 512 may have a smaller length-direction dimension (e.g., in y-axis direction) compared to the release film 510 (e.g., first release film 511) positioned below the second release film 512.

After the second release film 512 is stacked, a process of stacking the prepreg 520 on the flexible substrate layer 410 on which the second release film 512 is stacked may be additionally performed. After the prepreg 520 is stacked, an operation of removing the prepreg 520 on the second release film 512 by pressurizing the prepreg 520 or cutting the prepreg 520 may be additionally performed.

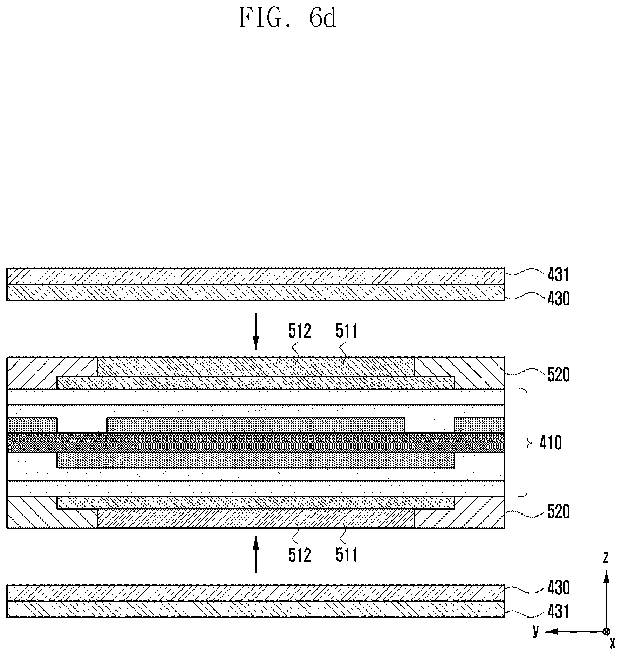

With reference to FIG. 6D, an operation of forming a conductor layer on the prepreg 520 and the release film 510 (e.g., second release film 512) may be performed. The conductor layer may be formed by stacking a laminated film in which a conductor layer and a base layer are laminated such as a copper clad laminate (CCL) or FCCL. In various embodiments, the conductor of the laminated film may be patterned by means such as etching.

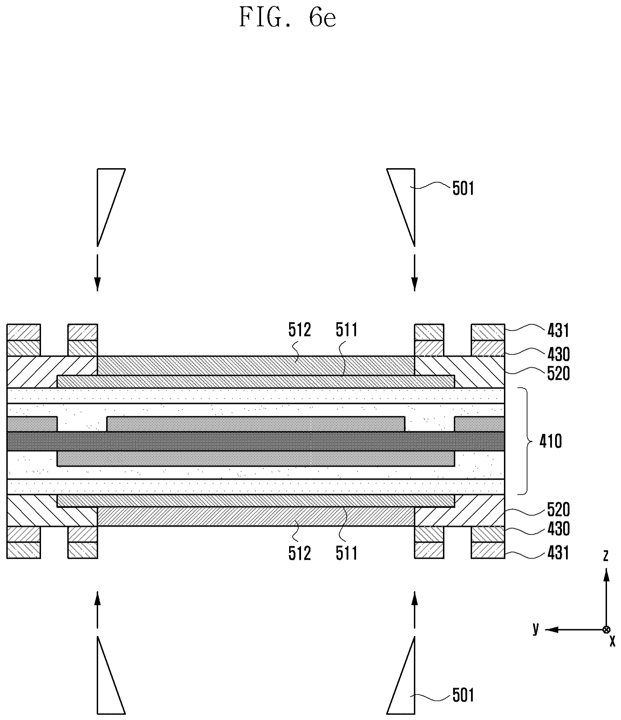

With reference to FIG. 6E, a cutting and removing operation may be performed on the stacked conductor layer. When cutting and removing the conductor layer, the base layer stacked together with the conductor layer may be cut and removed together. The cutting may be performed at the boundary region between the rigid part and the flexible part of the rigid flexible printed circuit board 401. The cutting may be performed by a means such as a blade mold 501.

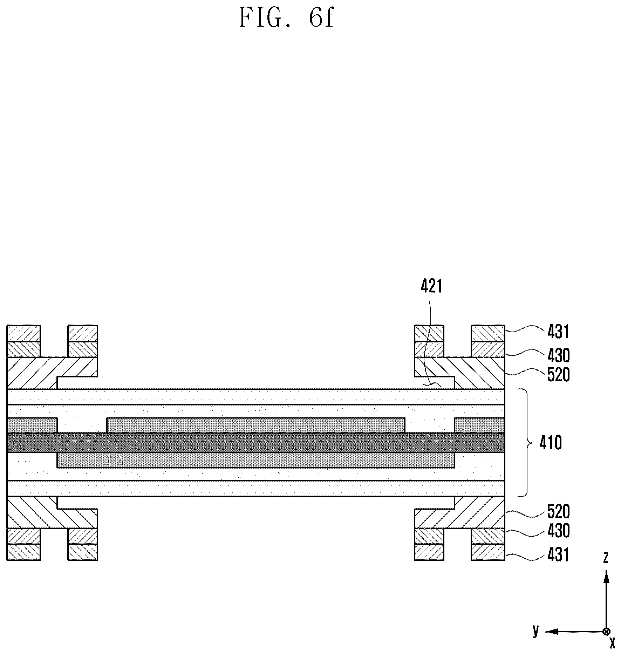

With reference to FIG. 6F, the release film 510 (e.g., first release film 511 and second release film 512) may be removed. By removing the release film 510, a recessed portion 421 may be formed on the side surface of the prepreg 520. In various embodiments, the release film 510 may be removed by attaching it to an adhesive tape and detaching the adhesive tape. Additionally, in various embodiments, the release film 510 may be removed by dissolving it with a solvent.

In various embodiments, the number of release films 510 and the length-direction dimension (e.g., y-axis dimension) of each release film 510 may be determined according to the shape of the recessed portion 421. For example, when the rigid flexible printed circuit board 401 is manufactured so that the shape of the recessed portion 421 has a single-stepped step shape as illustrated in FIG. 6F, two release films 510 having different lengths may be used as shown in FIG. 6C. In addition, for example, when the rigid flexible printed circuit board 401 is manufactured so that the recessed portion 421 has a two-stepped step shape as shown in FIG. 5A, the rigid flexible printed circuit board 401 including a recessed portion 421 having a two-stepped step shape may be manufactured by using three release films 510 having different lengths.

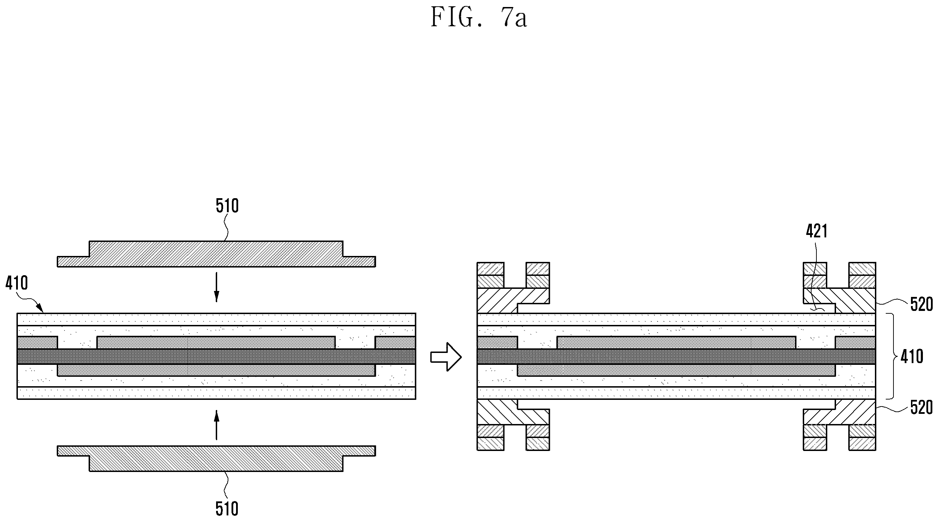

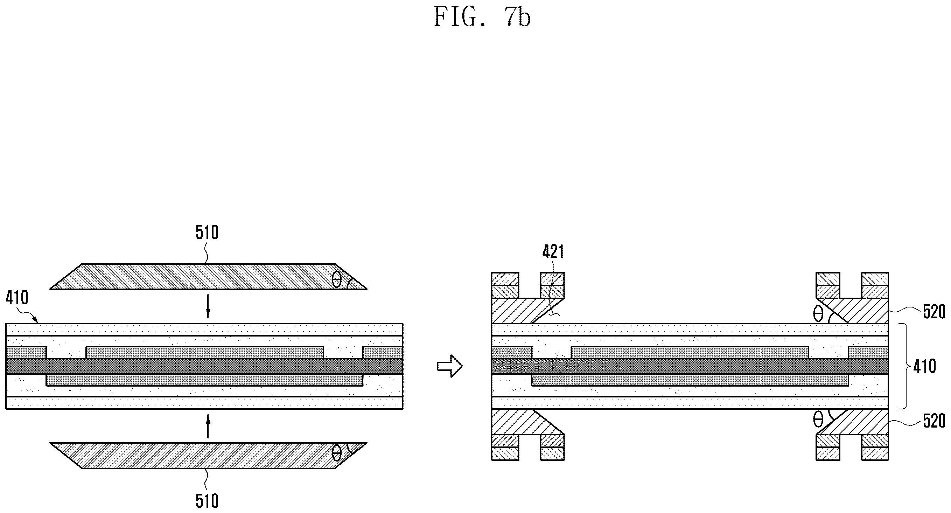

FIGS. 7A and 7B are schematic diagrams illustrating operations for manufacturing a rigid flexible printed circuit board 401 according to various embodiments.

With reference to FIGS. 7A and 7B, the side shape (e.g., shape of the surface facing in y-axis direction) of the release film 510 stacked on the flexible substrate layer 410 may have a shape corresponding to the side shape of the recessed portion 421. For example, in the release film 510, the length of the surface facing the flexible substrate may be longer than that of the surface located in the opposite direction of the flexible substrate so that the invagination distance may increase as the recessed portion 421 approaches the flexible substrate layer 410 with respect to the thickness direction (z-axis direction) of the rigid flexible circuit board as shown in FIGS. 5A and 5B.

For example, with reference to FIG. 7A, the side surface of the release film 510 may have a step shape corresponding to the step-shaped recessed portion 421. Also, for example with reference to FIG. 7B, the side surface of the release film 510 may have an angle (θ) corresponding to the angle (e.g., θ in FIG. 5B) of the recessed portion 421 having an inclined shape. Hence, by stacking the prepreg 520 on the flexible substrate layer 410 on which the release film 510 having the corresponding shape described above is stacked, a rigid flexible printed circuit board 401 including a rigid insulating layer 420 having a recessed portion 421 of the shape described above can be manufactured.

In various embodiments, the operation of removing the release film 510 may be performed after the resin of the prepreg 520 is cured. Thereby, when removing the release film 510, the shape of the recessed portion 421 formed in the uncured prepreg 520 may be prevented from collapsing during the detachment process of the release film 510.

The rigid flexible printed circuit board according to various embodiments of the disclosure may be a rigid flexible printed circuit board having a flexible part 402 and a rigid part 403. The rigid flexible printed circuit board may include a flexible substrate layer 410 that includes at least one flexible conductor layer 411 and at least one flexible insulating layer 412 stacked on the at least one flexible conductor layer 411. The rigid flexible printed circuit board may include a rigid insulating layer 420, in the rigid part 403, which is stacked on the flexible substrate layer 410 and has higher rigidity compared to the flexible insulating layer 412. The rigid insulating layer 420 may include a recessed portion 421 that is formed by recessing the side surface of the rigid insulating layer 420 at the boundary between the flexible part 402 and the rigid part 403.

In various embodiments, the recessed portion 421 may have an invagination distance that increases as it gets closer to the flexible substrate layer 410 with respect to the thickness direction of the circuit board 401.

In various embodiments, the recessed portion 421 may have a step shape in which the invagination distance increases stepwise as it gets closer to the flexible substrate layer 410 with respect to the thickness direction of the circuit board 401.

In various embodiments, the recessed portion 421 may have a shape forming an acute angle (θ) with the surface of the flexible substrate layer 410 such that the invagination distance continuously increases as it gets closer to the flexible substrate layer 410 with respect to the thickness direction of the circuit board 401.

In various embodiments, the electronic device includes an internal frame having a surface facing in a first direction and a side frame disposed perpendicular to the surface facing in the first direction,

The rigid part 403 may be disposed parallel to the side frame, and the flexible part 402 may be positioned within the electronic device so as to be bent at least partially parallel to the surface facing in the first direction.

In various embodiments, the rigid flexible printed circuit board may include a conductor layer positioned on the rigid insulating layer 420 in the rigid part 403, and electrical components disposed on the rigid part 403 and electrically connected to the conductor layer.

In various embodiments, the rigid flexible printed circuit board may be manufactured by a method including an operation of attaching a release film 510 on the flexible substrate layer 410, an operation of stacking a prepreg 520 on the flexible substrate layer 410 to which the release film 510 is attached, and an operation of removing the release film 510.

The manufacturing method of the disclosure is a method for manufacturing a rigid flexible printed circuit board 401 having a flexible part 402 and a rigid part 403, and may include an operation of attaching a release film 510 having a preset length on a flexible substrate.

The manufacturing method may include an operation of stacking a prepreg 520 on the flexible substrate to which the release film 510 is attached. The manufacturing method may include an operation of removing the release film 510.

In various embodiments, the manufacturing method may further include, after the operation of stacking the prepreg 520 is performed, an operation of attaching a second release film 512 having a shorter length compared to the release film 510 on the release film 510, and an operation of additionally stacking the prepreg 520 on the flexible substrate to which the second release film 512 is attached.

In various embodiments, the operation of stacking the prepreg 520 may further include an operation of pressurizing the stacked prepreg 520.

In various embodiments, in the release film 510, the length of the surface facing the flexible substrate layer 410 may be longer than the length of the surface opposite to the surface facing the flexible substrate layer 410.

In various embodiments, the release film 510 may have a side surface having a specific angle (θ) less than 90 degrees with the surface facing the flexible substrate layer 410.

In various embodiments, the operation of removing the release film 510 may be performed after the prepreg 520 is cured.

It will be understood that all of the embodiments and their technical features described above may be combined with each other in each and every combination, as long as there is no conflict between two embodiments or features. That is, any and all combinations of two or more of the embodiments described above are contemplated and are included within the present disclosure. One or more features of any embodiment may be incorporated into any other embodiment and may provide corresponding benefits or advantages.

In addition, the embodiments disclosed in this document including this specification and drawings are only specific examples presented to easily explain the technical contents according to the embodiments disclosed in this document and to help understand the embodiments disclosed in this document, and are not intended to limit the scope of the embodiments disclosed in this document. Therefore, the scope of the various embodiments disclosed in this document should be interpreted to include all changes or modifications derived based on the technical ideas of the various embodiments disclosed in this document in addition to those embodiments disclosed herein.

## Claims

1. An electronic device comprising a circuit board having a flexible part (402) and a rigid part (403), the circuit board including:
a flexible substrate layer (410) including at least one flexible conductor layer (411) and at least one flexible insulating layer (412) stacked on the at least one flexible conductor layer (411); and
a rigid insulating layer (420) stacked on the flexible substrate layer (410), in the rigid part (403) of the circuit board, and having higher rigidity compared to the flexible insulating layer (412),
wherein the rigid insulating layer (420) includes a recessed portion (421) that is formed by recessing a side surface of the rigid insulating layer (420) at a boundary between the flexible part (402) and the rigid part (403).

2. The electronic device of claim 1, wherein the recessed portion (421) has an invagination distance that increases as it gets closer to the flexible substrate layer (410) with respect to a thickness direction of the circuit board.

3. The electronic device of claim 2, wherein the recessed portion (421) has a step shape in which the invagination distance increases stepwise as it gets closer to the flexible substrate layer (410) with respect to the thickness direction of the circuit board.

4. The electronic device of claim 2, wherein the recessed portion (421) has a shape forming a specific angle (θ) with a surface of the flexible substrate layer (410) in a manner that the invagination distance continuously increases as it gets closer to the flexible substrate layer (410) with respect to the thickness direction of the circuit board.

5. The electronic device of claim 1, wherein:
the electronic device comprises an internal frame having a surface facing in a first direction and a side frame disposed perpendicular to the surface facing in the first direction; and
the rigid part (403) is disposed parallel to the side frame, and the flexible part (402) is positioned within the electronic device so as to be bent at least partially parallel to the surface facing in the first direction.

6. The electronic device of claim 1, comprising:
a conductor layer positioned on the rigid insulating layer (420) in the rigid part (403); and
electrical components disposed on the rigid part (403) and electrically connected to the conductor layer.

7. The electronic device of claim 1, wherein the circuit board is manufactured by a method composed of attaching a release film (510) on the flexible substrate layer (410), stacking a prepreg (520) on the flexible substrate layer (410) to which the release film (510) is attached, and removing the release film (510).

8. A rigid flexible printed circuit board having a flexible part (402) and a rigid part (403), comprising:
a flexible substrate layer (410) including at least one flexible conductor layer (411) and at least one flexible insulating layer (412) stacked on the at least one flexible conductor layer (411); and
a rigid insulating layer (420) stacked on the flexible substrate layer (410), in the rigid part (403) of the circuit board, and having higher rigidity compared to the flexible insulating layer (412),
wherein the rigid insulating layer (420) includes a recessed portion (421) that is formed by recessing a side surface of the rigid insulating layer (420) at a boundary between the flexible part (402) and the rigid part (403).

9. The rigid flexible printed circuit board of claim 8, wherein the recessed portion (421) has an invagination distance that increases as it gets closer to the flexible substrate layer (410) with respect to a thickness direction of the circuit board.

10. The rigid flexible printed circuit board of claim 9, wherein the recessed portion (421) has a step shape in which the invagination distance increases stepwise as it gets closer to the flexible substrate layer (410) with respect to the thickness direction of the circuit board.

11. The rigid flexible printed circuit board of claim 9, wherein the recessed portion (421) has a shape forming a specific angle (θ) with a surface of the flexible substrate layer (410) in a manner that the invagination distance continuously increases as it gets closer to the flexible substrate layer (410) with respect to the thickness direction of the circuit board.

12. The rigid flexible printed circuit board of claim 8, wherein the rigid flexible printed circuit board is disposed inside an electronic device, the electronic device comprising an internal frame having a surface facing in a first direction and a side frame disposed perpendicular to the surface facing in the first direction; and
wherein the rigid part (403) is disposed parallel to the side frame, and the flexible part (402) is positioned within the electronic device so as to be bent at least partially parallel to the surface facing in the first direction.

13. The rigid flexible printed circuit board of claim 8, comprising:
a conductor layer positioned on the rigid insulating layer (420) in the rigid part (403); and
electrical components disposed on the rigid part (403) and electrically connected to the conductor layer.

14. The rigid flexible printed circuit board of claim 8, wherein the circuit board is manufactured by a method composed of attaching a release film (510) on the flexible substrate layer (410), stacking a prepreg (520) on the flexible substrate layer (410) to which the release film (510) is attached, and removing the release film (510).
